# EUROPEAN PATENT APPLICATION

(11) **EP 1 465 241 A2**
(43) Date of publication of application: **06.10.2004**
(21) Application number: 04075898.9
(22) Date of filing: 25.03.2004
(51) Int. Cl.: H01L 21/00

(54) **Apparatus and method for cleaning an electronic device**

(30) Priority: 04.04.2003 US 408174
(71) Applicant: ASM Technology Singapore Pte Ltd., Singapore 768924 (SG)
(72) Inventor: Ho, Shu Chuen, Singapore 298189 (SG); Kuah, Teng Hock, Singapore 760321 (SG); Lee, Shuai Ge, Singapore 734787 (SG); Pang, Hung Khoon, Singapore 550552 (SG); Zhao, Bao Zong, Singapore 760759 (SG)
(74) Representative: Griebling, Onno

(57) **Abstract**

An apparatus and method is provided for processing an electronic device, particularly the molding and cleaning of the device. Molding means encapsulate the electronic device with a molding compound. Thereafter, stain from one or more surfaces of the electronic device is removed by a stain removal device adapted to impact the electronic device with a polishing agent. A residue removal system then removes residue from the one or more surfaces of the electronic device.

## Description

### Field of the invention

The invention relates to post-encapsulation cleaning of a molded electronic device, such as a semiconductor leadframe package, and especially but not limited to, the cleaning of the molded device when molding was performed without an adhesive masking tape attached to a surface of the device to limit mold flash or bleed during molding.

### Background and prior art

Molding in a semiconductor leadframe package is performed to protect a semiconductor integrated circuit die attached to a metal leadframe substrate in a conventional packaging process. Molding is carried out in a mold press or molding machine. Typically, the molding machine includes a mold chase with two mold halves, which sandwich the leadframe with the semiconductor dice positioned within cavities formed in the mold halves. Encapsulation material, such as epoxy molding compound ("EMC"), is introduced into the cavity of the mold, thereby encapsulating the semiconductor dice.

For certain types of semiconductor packages, such as Quad-Flat No-lead ("QFN") packages, EMC is molded around a semiconductor die on only one side of the leadframe substrate. The opposite side of the substrate is substantially free of EMC. Therefore, a practice has developed in the industry to use a specially-designed adhesive tape that seals a non-molded surface of a leadframe in order to prevent EMC from seeping into the non-molded side of the substrate and causing flashing.

However, using such adhesive tape is not cost-effective since each piece of tape should preferably cover an entire leadframe surface, and the tape cannot be re-used. It is also not environmentally friendly. Furthermore, there is a need for further processing, such as equipment to peel off the tape without damaging the leadframe or packaged device. Nonetheless, some remnants of adhesivity may remain on the leadframe that may affect handling by other equipment down the production line. Therefore, it would be desirable to avoid the use of adhesive masking tape during molding of such packages.

One method to avoid using adhesive tape is to use an elastomeric material coated onto one of the mold halves in place of the adhesive masking tape to seal a surface of the leadframe to prevent flow of encapsulation material to the non-molded surface. Nonetheless, such elastomeric material while reducing leakage of encapsulation material, may still result in some mold flash or bleeding since it may not adhere as tightly to the leadframe as adhesive tape. Indeed, some mold flash or bleeding may still occur using the traditional adhesive masking tape. Thus, it would be desirable to be able to effectively remove stain, particularly in the form of mold flash or bleeding of molding compound during encapsulation, to remove any unwanted molding compound that might affect the quality of the finished product. This should be done as far as possible to enhance product quality.

### Summary of the Invention

It is an objective of the present invention to provide an improved system for polishing and cleaning a leadframe substrate after molding to remove stain, such as that produced by mold flash or bleeding.

According to a first aspect of the invention, there is provided an apparatus for processing an electronic device comprising: molding means for encapsulating the electronic device with a molding compound; a stain removal device adapted to impact the electronic device with a polishing agent for removing stain from one or more surfaces of the electronic device; and a residue removal system adapted to remove residue from the one or more surfaces of the electronic device.

According to a second aspect of the invention, there is provided a method for processing an electronic device comprising the steps of: encapsulating the electronic device with a molding compound; impacting the electronic device with a polishing agent to remove stain from one or more surfaces of the electronic device; and removing residue from the one or more surfaces of the electronic device.

It will be convenient to hereinafter describe the invention in greater detail by reference to the accompanying drawings which illustrate one embodiment of the invention. The particularity of the drawings and the related description is not to be understood as superseding the generality of the broad identification of the invention as defined by the claims.

### Brief description of the Drawings

Examples of a method and apparatus for cleaning a molded electronic device in accordance with the invention will now be described with reference to the accompanying drawings, in which:
Fig. 1 is a schematic layout of a molding system incorporating a cleaning module according to a preferred embodiment of the invention;
Fig. 2 is a schematic layout of the cleaning module according to the preferred embodiment of the invention;
Figs. 3(a)-(c) are cross-sectional illustrations of steps involved in a molding process;
Figs. 4a and 4b are isometric views of a top surface and a bottom surface respectively of a substrate during polishing of the substrate with a multiple-nozzle gun;
Fig. 5 is an isometric view of the top surface of the substrate during a cleaning process within a secondary cleaning module; and
Fig. 6 is an isometric view of the bottom surface of the substrate, which is a view of the substrate and cleaning module of Fig. 5 when inverted.

### Detailed description of the preferred embodiment

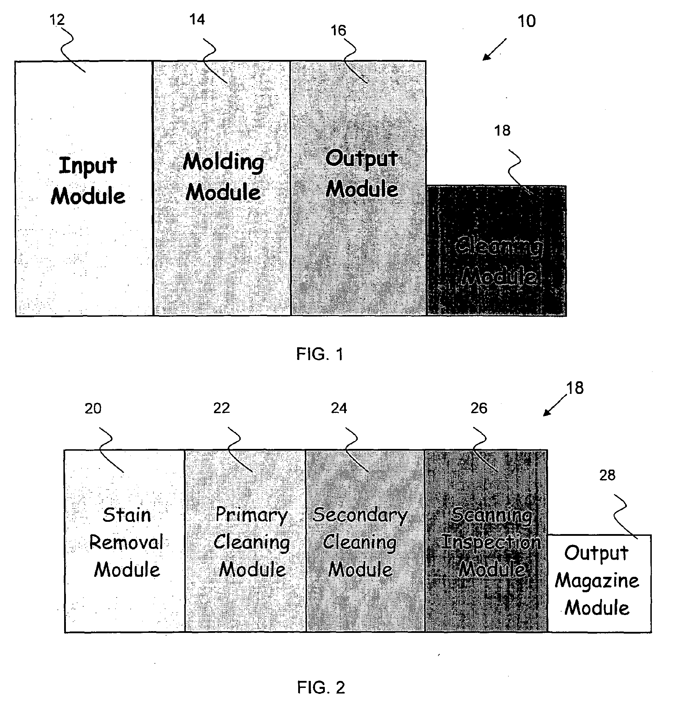

Fig. 1 is a schematic layout of a molding system 10 incorporating a cleaning module 18 according to the preferred embodiment of the invention. Electronic devices, such as semiconductor substrates with dice attached thereon, are loaded into an input module 12 for preheating and for transferring to molding means of a molding module 14 via an on-loader, together with a molding compound, such as an epoxy molding compound ("EMC").

In the molding module 14, the substrate and EMC are placed into a molding tool of the molding means, in particular a mold press consisting of mold halves sandwiching the substrate for molding. Since in the preferred embodiment, only one side of the substrate is to be molded to produce a QFN package, preferably at least one mold half corresponding to a non-molded side of the substrate is coated with an elastomeric material (such as SOFTTEC™ developed by the applicants) to prevent flashing and bleeding, and to act as a mechanical seal to prevent seepage of EMC to the non-molded side during a molding process. At an output module 16, encapsulated substrates are inspected for defects such as flash, voids and incomplete fill. Remnants from a gate and runner system, also known as cull, are usually removed at this location. Details of the input module 12, molding module 14 and output module 16 will not be further elaborated as equipment that are fairly well-known in the art may be utilized.

At the cleaning module 18, any stains formed during molding, especially mold flash and/or bleed, are removed by cleaning the encapsulated substrates externally with cleaning media, as will be described in more detail below.

Fig. 2 is a schematic layout of the cleaning module 18 according to the preferred embodiment of the invention. The cleaning module 18 comprises further sub-modules, namely stain removal means which may be in the form of a stain removal module 20, a primary cleaning module 22 and a secondary cleaning module 24 which may collectively form a residue removal system, an optical scanning inspection module 26 comprising an optical scanning device and an output magazine module 28.

In the stain removal module 20, encapsulated substrates are subject to stain removal by impacting them with a polishing agent. The polishing agent is preferably plasma or an abrasive media. At this station, any stain, such as molding flash and/or bleed, are removed using blasting by an abrasive medium or chemical plasma polishing, wherein these media will be in direct contact with any exposed area of the substrate. This station is preferably under a negative pressure environment. The abrasive media may comprise compounds such as grains of plastic or silica, metal in the form of grains of aluminium or copper, and metal alloys in the form of brass. They are impacted at the surface to be cleaned. Other relatively soft materials may be used if they are sufficiently abrasive to remove stain, but not so that they will damage the leadframe or semiconductor package during blasting. Plasma cleaning may also be used, by placing the encapsulated substrates into a commercially-available plasma machine, and it will not be necessary to describe the plasma cleaning process in further detail herein.

In the primary cleaning module 22 of the residue removal system, any residue in the form of stain and polishing agent remnants on the post-encapsulation substrate's surface are removed from the substrate surface. This process uses pressurized clean air, preferably ionized, directed at the substrate to neutralize static charge that has been generated during the packaging process and to blow away or dislodge residue.

The secondary cleaning module 24 of the residue removal system acts as a final gate to ensure that the post-encapsulation substrate is absolutely clean of remnants, for example, stain in the form of mold flash and/or bleed, and polishing media where blasting media was used during stain removal. Thereafter, the substrate may be passed through an optical scanning inspection module 26 to search for any surface or other visually-identifiable defects on the substrate.

After the substrate has been inspected to ensure that it is not defective, the cleaned substrate is passed to an output magazine module 28 and placed into a magazine, such as one with a slotted or stack design, for removal from the system. Preferably, double-doors are used to divide each sub-module 20, 22, 24, 26, 28 from one another to avoid interference between respective processes.

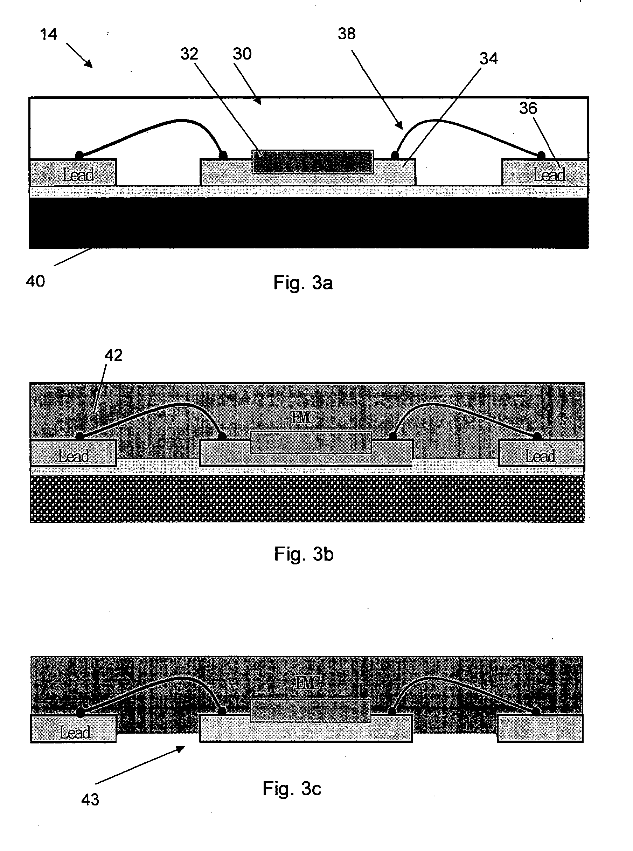

Figs. 3(a)-(c) are cross-sectional illustrations of steps involved in a molding process. In particular, they illustrate a molding process where only one side of a leadframe substrate is to be molded. Fig. 3(a) shows a mold cavity 30 of the press module 14 into which a leadframe substrate has been inserted. The substrate comprises generally of die pads 34 and leads 36 Semiconductor dice 32 are attached onto the die pads 34. An elastomeric material 40, which may comprise a mold coating developed by the applicants herein with the trade name SOFTTEC™, is formed at least partially on the mold press, in particular, on a bottom mold piece of the mold press. When top and bottom mold pieces are closed so as to sandwich the substrate, the elastomeric material 40 presses against the bottom surface of the substrate, in order to seal off the bottom surface of the substrate opposite to a molding side.

Fig. 3(b) shows the mold cavity 30 during molding. The elastomeric material 40 is pressing against the bottom surface of the substrate as a molding compound 42, such as EMC is injected into the mold cavity 30. The mold cavity 30 is filled with molding compound 42, and the molding compound 42 is allowed to harden.

Fig. 3(c) shows a completed QFN package when released from the mold press. Only one side of the substrate is molded. Some molding compound 42 may have seeped through during molding, and stains due to mold flash or bleed may form on the bottom surface 43 of the substrate.

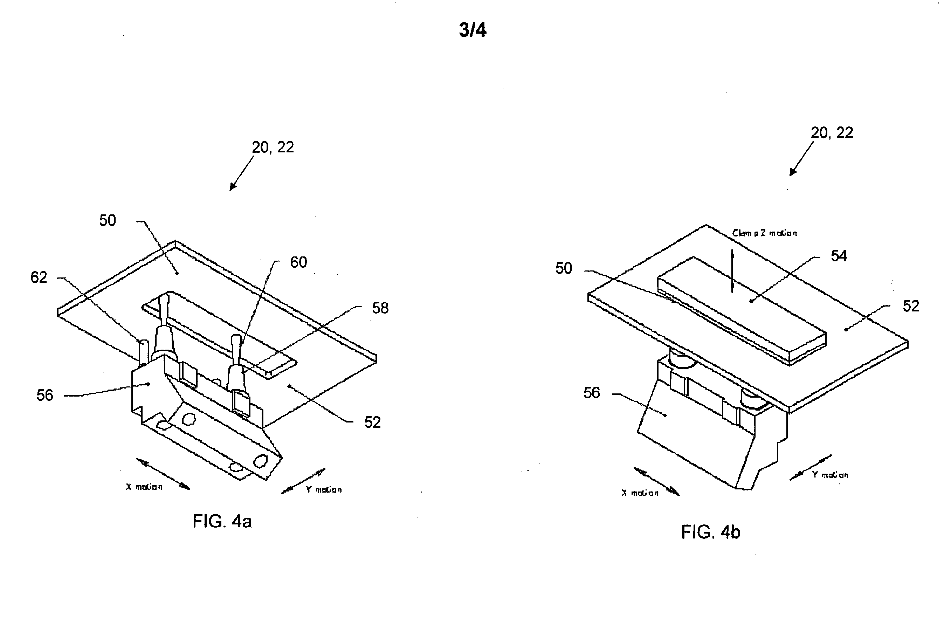

Figs. 4a and 4b are isometric views of a bottom surface and a top surface respectively of a substrate 50 during polishing of the substrate 50 with a multiple-nozzle gun 56, which may occur in the stain removal module 20 and primary cleaning module 22 of the cleaning module 18. Although the stain removal module 20 and primary cleaning module 22 are integrated in this description, they may also be separated, as shown schematically in Fig. 2. Referring to Fig. 4a, the multiple-nozzle gun 56 may consist of different types of nozzles. One type of nozzle may be abrasive-blasting nozzles 58 to discharge a polishing agent 60 and another type of nozzle may be air-flow guns 62 to discharge pressurized air. The substrate 50 is mounted onto clamping device including a base plate 52 that has an opening in order to expose the non-molded surface of the substrate 50, corresponding to the locations of the molded packages on the substrate 50, to the multiple-nozzle gun 56.

The multiple-nozzle gun 56 is adapted to move along a horizontal plane, which may be conveniently referred to as the x and y directions. The abrasive-blasting nozzles 58 are first activated to blast the polishing agent 60 against the exposed surface of the substrate 50 through the opening of the base plate 52, while the multiple-nozzle gun 56 moves in the x and y directions so that the whole substrate surface is cleaned. Stain in the form of mold flash and/or bleed may be removed this way. Thereafter, the abrasive-blasting nozzles 58 are de-activated and the air-flow guns 62 are activated for primary cleaning. As mentioned previously, primary cleaning involves using pressurized clean air, preferably ionized, to neutralize static charge that has been generated during the packaging process and the pressurized air-flow detaches any residue, for example, stain remaining on the substrate surface, and remnants of the polishing agent 60 on the substrate's surface.

Referring to Fig. 4b, a clamping plate 54 of the clamping device clamps the top surface of the substrate 50 to the base plate 52 to secure it during stain removal and primary cleaning. The clamping plate 54 is preferably capable of Z-direction motion to move up and down in order to unclamp and clamp substrates to be cleaned.

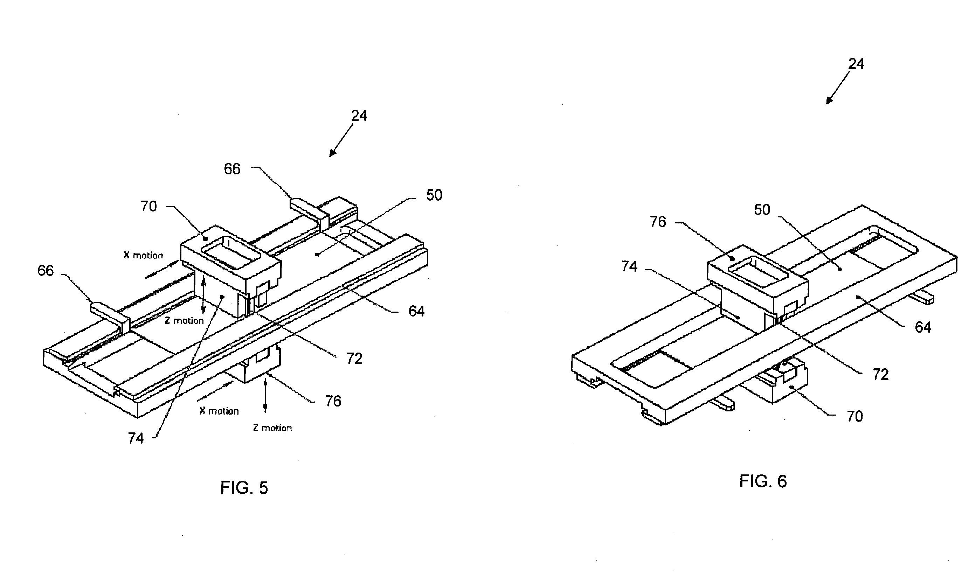

Fig. 5 is an isometric view of the top surface of the substrate 50 during a cleaning process within the secondary cleaning module 24. The substrate 50 is placed onto a track 64 on which it may be transported. Steppers 66 incrementally shift the substrate 50 along the track 64 by pushing it along. A top cleaner 70 is positioned over the track 64 so that the substrate 50 is cleaned as it is moved along the track 64. The top cleaner 70 is adapted to move up and down in the z direction, and includes a cleaning device, such as a top brusher 72, and a top vacuum suction device 74 to further clean the substrate 50 of residue.

Fig. 6 is an isometric view of the bottom surface of the substrate 50, which is a view of the substrate and cleaning module of Fig. 5 when inverted. Essentially, the layout with respect to the bottom surface of the substrate 50 is similar to that of the top surface. A bottom cleaner 76 is positioned adjacent the track 64. However, it may not be necessary for the bottom cleaner 76 to move up and down as in the case of the top cleaner 70. The bottom cleaner 76 also includes a cleaning device, such as a bottom brusher 72 and a bottom vacuum suction device 74.

The invention described herein is susceptible to variations, modifications and/or additions other than those specifically described and it is to be understood that the invention includes all such variations, modifications and/or additions which fall within the spirit and scope of the above description.

## Claims

1. Apparatus for processing an electronic device comprising:
molding means for encapsulating the electronic device with a molding compound;
a stain removal device adapted to impact the electronic device with a polishing agent for removing stain from one or more surfaces of the electronic device; and
a residue removal system adapted to remove residue from the one or more surfaces of the electronic device.

2. Apparatus according to claim 1, wherein the polishing agent is selected from the group consisting of plasma and an abrasive medium.

3. Apparatus according to claim 2, wherein the abrasive medium is selected from the group consisting of grains of plastic, silica, metals and metal alloys.

4. Apparatus according to any one of the preceding claims, wherein the residue removal system includes a pressurized air generation device to direct pressurized air at the electronic device to blow residue from the one or more surfaces of the electronic device.

5. Apparatus according to claim 4, wherein the pressurized air is ionized.

6. Apparatus according to any one of the preceding claims, wherein the residue removal system includes a cleaning device to dislodge residue from the one or more surfaces of the electronic device.

7. Apparatus according to claim 6, wherein the cleaning device comprises a brush.

8. Apparatus according to any one of the preceding claims, wherein the residue removal system includes a vacuum suction device to suck residue from the one or more surfaces of the electronic device.

9. Apparatus according to any one of the preceding claims, wherein the molding means includes a mold press that is coated at least partially with an elastomeric material.

10. Apparatus according to any one of the preceding claims, including an optical scanning device adapted to inspect a molded electronic device.

11. Apparatus according to any one of the preceding claims, wherein the stain removal device includes a clamping device having an opening whereby to hold the electronic device and expose a surface of the electronic device to allow impact by the polishing agent through the opening.

12. A method for processing an electronic device comprising the steps of:
encapsulating the electronic device with a molding compound;
impacting the electronic device with a polishing agent to remove stain from one or more surfaces of the electronic device; and
removing residue from the one or more surfaces of the electronic device.

13. A method according to claim 12, wherein the polishing agent is selected from the group consisting of plasma and an abrasive medium.

14. A method according to claim 13, wherein the abrasive medium is selected from the group consisting of grains of plastic, silica, metals and metal alloys.

15. A method according to any one of claims 12 to 14, wherein the step of removing residue includes the step of generating pressurized air at the electronic device to blow away residue from the one or more surfaces of the electronic device.

16. A method according to claim 15, wherein the pressurized air is ionized.

17. A method according to any one of claims 12 to 16, wherein the step of removing residue includes the step of using a brush to dislodge residue from the one or more surfaces of the electronic device.

18. A method according to any one of claims 12 to 17, wherein the step of removing residue includes the step of using vacuum suction to suck residue from the one or more surfaces of the electronic device.

19. A method according to any one of claims 12 to 18, including coating at least partially a mold press used for encapsulating the electronic device with an elastomeric material.

20. A method according to any one of claims 12 to 19, including inspecting a molded electronic device with an optical scanning device.

21. A method according to any one of claims 12 to 20, including clamping the electronic device with a clamping plate during the step of impacting the electronic device with a polishing agent, wherein the clamping device has an opening to expose a surface of the electronic device, and impacting the polishing agent through the opening.
